# EUROPEAN PATENT APPLICATION

(11) **EP 2 040 284 A1**
(43) Date of publication of application: **25.03.2009**
(21) Application number: 07768368.8
(22) Date of filing: 09.07.2007
(51) Int. Cl.: H01L 21/027, G02B 21/12, G02B 21/18, G03F 7/20

(54) **ILLUMINATING OPTICAL APPARATUS, EXPOSURE APPARATUS AND DEVICE MANUFACTURING METHOD**

(30) Priority: 12.07.2006 JP 2006191348
(71) Applicant: Nikon Corporation, Chiyoda-ku Tokyo 100-8331 (JP)
(72) Inventor: MIZUNO, Yasushi, Tokyo 100-8331 (JP); SHIGEMATSU, Koji, Tokyo 100-8331 (JP); MURAMATSU, Kouji, Tokyo 100-8331 (JP); TANAKA, Hirohisa, Tokyo 100-8331 (JP); TANITSU, Osamu, Tokyo 100-8331 (JP)
(74) Representative: Hooiveld, Arjen Jan Winfried
(86) International application number: PCT/JP2007/063644
(87) International publication number: WO 2008/007633

(57) **Abstract**

An illumination optical apparatus is able to individually illuminate two regions separate from each other, under required illumination conditions. The illumination optical apparatus comprises a first illumination system to illuminate a first illumination region (M1) and a second illumination region to illuminate a second illumination region (M2). The first illumination system includes a first variable system (11, 13, 14) which varies a shape or size of a light intensity distribution on an illumination pupil of the first illumination system and the second illumination system includes a second variable system (21, 23, 24) which varies a shape or size of a light intensity distribution on an illumination pupil of the second illumination system. The first variable system and the second variable system vary the light intensity distribution on the illumination pupil of the first illumination system and the light intensity distribution on the illumination pupil of the second illumination system independently of each other.

## Description

### Technical Field

The present invention relates to illumination optical apparatus, exposure apparatus, and device manufacturing methods and, more particularly, to an illumination optical apparatus suitable for an exposure apparatus for manufacturing such devices as semiconductor devices, imaging devices, liquid-crystal display devices, and thin-film magnetic heads by a lithography process.

### Background Art

The photolithography process for manufacturing the semiconductor devices and others is carried out using an exposure apparatus for projecting a pattern image of a mask (or reticle) through a projection optical system onto a photosensitive substrate (a wafer, a glass plate, or the like coated with a photoresist) to effect an exposure thereof. The ordinary exposure apparatus is arranged to form a pattern of one kind in one shot area (unit exposure region) on the photosensitive substrate.

In contrast to it, a method proposed for improvement in throughput is a double exposure method of effecting exposures of patterns of two kinds in a superimposed state in one shot area on a photosensitive substrate to form one synthetic pattern (cf. Patent Document 1).

Patent Document 1: Japanese Patent Application Laid-open No. 2000-21748

### Disclosure of the Invention

### Problem to be Solved by the Invention

It is important for the exposure apparatus of the double exposure method to individually illuminate, for example, regions on two masks separate from each other, e.g., to individually illuminate the regions under required illumination conditions according to characteristics of transfer patterns.

The present invention has been accomplished in view of the above-described problem and an object of the present invention is to provide an illumination optical apparatus capable of individually illuminating two regions separate from each other, under required illumination conditions. Another object of the present invention is to provide an exposure apparatus capable of performing an exposure of a fine pattern at high throughput on a photosensitive substrate by the double exposure method, using the illumination optical apparatus individually illuminating two regions separate from each other, under required illumination conditions.

### Means for Soling the Problem

In order to solve the above problem, a first aspect of the present invention provides an illumination optical apparatus comprising: a first illumination system including a first illumination optical path and illuminating a first illumination region; and a second illumination system including a second illumination optical path independent of the first illumination optical path and illuminating a second illumination region,
wherein the first illumination system includes a first variable system which varies a shape or size of a light intensity distribution on an illumination pupil of the first illumination system,
wherein the second illumination system includes a second variable system which varies a shape or size of a light intensity distribution on an illumination pupil of the second illumination system, and
wherein the first variable system and the second variable system vary the light intensity distribution on the illumination pupil of the first illumination system and the light intensity distribution on the illumination pupil of the second illumination system independently of each other.

A second aspect of the present invention provides another illumination optical apparatus comprising: a first illumination system including a first illumination optical path and illuminating a first illumination region; and a second illumination system including a second illumination optical path independent of the first illumination optical path and illuminating a second illumination region,
wherein the first illumination system includes a first polarization setting unit which sets a polarization state of light to illuminate the first illumination region, to a desired polarization state,
wherein the second illumination system includes a second polarization setting unit which sets a polarization state of light to illuminate the second illumination region, to a desired polarization state, and
wherein the first polarization setting unit and the second polarization setting unit vary the polarization state of the light to illuminate the first illumination region and the polarization state of the light to illuminate the second illumination region, independently of each other,
the illumination optical apparatus further comprising a light splitting member which splits incident light into two beams, guides one of the two beams to the first illumination optical path, and guides the other beam to the second illumination optical path.

A third aspect of the present invention provides an exposure apparatus comprising the illumination optical apparatus of the first aspect or the second aspect and performing an exposure of a pattern illuminated by the illumination optical apparatus, on a photosensitive substrate.

A fourth aspect of the present invention provides a device manufacturing method comprising: an exposure step of effecting the exposure of the pattern on the photosensitive substrate, using the exposure apparatus of the third aspect; and a development step of developing the photosensitive substrate after the exposure step.

### Effect of the Invention

The illumination optical apparatus according to the first aspect of the present invention is configured to vary the shape or size of the light intensity distribution on the illumination pupil of the first illumination system illuminating the first illumination region and the shape or size of the light intensity distribution on the illumination pupil of the second illumination system illuminating the second illumination region, independently of each other. As a consequence, the illumination optical apparatus is able to individually illuminate the first illumination region and the second illumination region separate from each other, under the required illumination conditions with the shape or size of the light intensity distribution on the illumination pupil as a parameter.

In the illumination optical apparatus according to the second aspect of the present invention, the first polarization setting unit setting the polarization state of the light to illuminate the first illumination region and the second polarization setting unit setting the polarization state of the light to illuminate the second illumination region are arranged in the respective optical paths split by the light splitting member. As a consequence, the illumination optical apparatus is able to individually illuminate the first illumination region and the second illumination region separate from each other, in optional polarization states even when there is a polarization characteristic of the light splitting member.

As a consequence, the exposure apparatus of the present invention is able to perform the exposure of the fine pattern at high throughput on the photosensitive substrate by the double exposure method and, therefore, to manufacture good devices at high throughput, using the illumination optical apparatus individually illuminating the two mutually separate regions under the required illumination conditions.

### Brief Description of the Drawings

Fig. 1 is a drawing schematically showing a configuration of an exposure apparatus according to a first embodiment of the present invention.
Fig. 2 is a drawing schematically showing a configuration of a projection optical system shown in Fig. 1.
Fig. 3 is a drawing wherein (a) shows a first illumination region of a rectangular shape formed on a first mask, (b) shows a second illumination region of a rectangular shape formed on a second mask, and (c) shows a state in which a pattern image of the first mask and a pattern image of the second mask are formed in a superimposed state on a wafer.
Fig. 4 is a drawing to illustrate an example of effect achieved based on the configuration of the first embodiment.
Fig. 5 is a drawing schematically showing a configuration of a first modification example.
Fig. 6 is a drawing schematically showing a configuration of a second modification example.
Fig. 7 is a drawing schematically showing a configuration of a third modification example.
Fig. 8 is a drawing schematically showing a configuration of a fourth modification example.
Fig. 9 is a drawing schematically showing a configuration of an exposure apparatus according to a second embodiment of the present invention.
Fig. 10 is a drawing schematically showing a configuration of a fifth modification example.
Fig. 11 is a drawing schematically showing a configuration of a sixth modification example.
Fig. 12 is a drawing schematically showing a configuration of a seventh modification example.
Fig. 13 is a drawing schematically showing a configuration of an eighth modification example.
Fig. 14 is a drawing schematically showing a configuration of a ninth modification example.
Fig. 15 is a drawing schematically showing a configuration of a tenth modification example.
Fig. 16 is a drawing schematically showing a configuration of an eleventh modification example.
Fig. 17 is a drawing schematically showing a configuration of a twelfth modification example.
Fig. 18 is a drawing schematically showing a configuration of a projection optical system consisting of a refracting system and folding mirrors.
Fig. 19 is a drawing schematically showing a configuration of a catadioptric double-headed projection optical system.
Fig. 20 is a flowchart of a method for manufacturing semiconductor devices.
Fig. 21 is a flowchart of a method for manufacturing a liquid-crystal display device.

### Description of Reference Symbols

- 5: control unit
- 10, 20: polarization setting units
- 11, 21: diffractive optical elements
- 13, 23: conical axicon systems
- 14, 24: zoom lenses
- 15, 25: micro fly's eye lenses
- M1, M2: masks
- PL: projection optical system
- W: wafer

### Best Mode for Carrying out the Invention

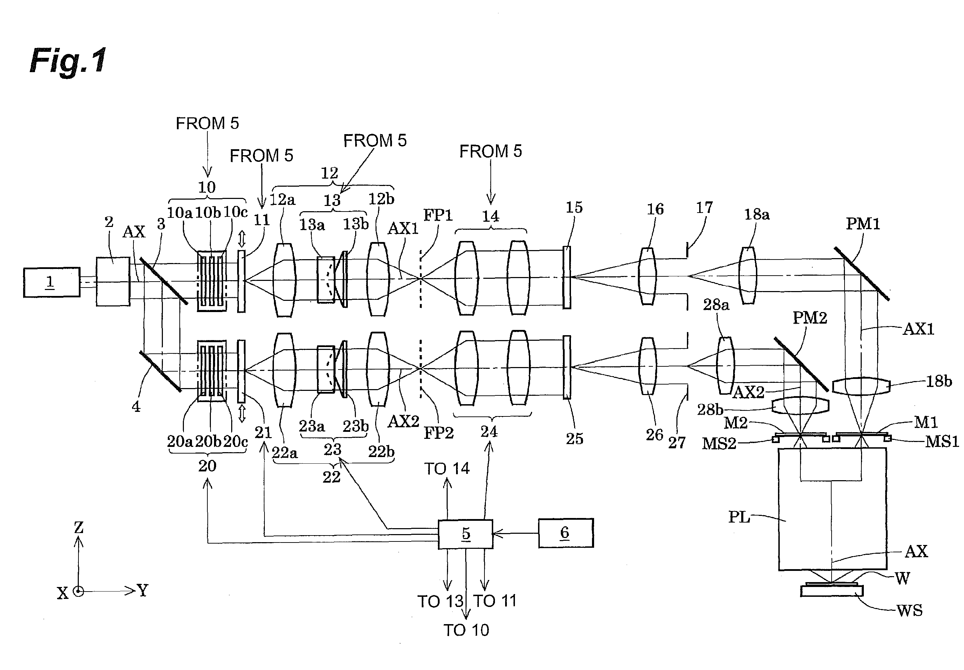

Embodiments of the present invention will be described on the basis of the accompanying drawings. Fig. 1 is a drawing schematically showing a configuration of an exposure apparatus according to the first embodiment of the present invention. In Fig. 1, the Z-axis is set along a direction of a normal to a wafer W being a photosensitive substrate, the Y-axis along a direction parallel to the plane of Fig. 1 in a surface of the wafer W, and the X-axis along a direction normal to the plane of Fig. 1 in the surface of the wafer W. With reference to Fig. 1, the exposure apparatus of the first embodiment is provided with a light source 1 for supplying exposure light (illumination light).

The light source 1 applicable herein can be, for example, an ArF excimer laser light source which supplies light with the wavelength of about 193 nm or a KrF excimer laser light source which supplies light with the wavelength of about 248 nm. A light beam emitted along the optical axis AX from the light source 1 is expanded into a beam of a required sectional shape by a shaping optical system 2 and the expanded beam is incident to a half mirror 3. The beam transmitted by the half mirror 3 is guided to a first illumination system which illuminates a first illumination region on a first mask M1. On the other hand, the beam reflected by the half mirror 3 is reflected by a path folding mirror 4 and then is guided to a second illumination system which illuminates a second illumination region on a second mask M2. The half mirror stated herein does not always have to be limited to one having a light quantity ratio of 1:1 in division of incident light. In the present embodiment, the half mirror 3 for amplitude division of incident light may be replaced by a polarization beam splitter for polarization division of incident light.

Since the first illumination system and the second illumination system have much the same basic configuration, the configurations and actions thereof will be described mainly with focus on the first illumination system. In the description thereof, the description of the second illumination system corresponding to the first illumination system will be given in parentheses. The first beam transmitted by the half mirror 3 and guided to the first illumination system (the second beam reflected by the half mirror 3 and guide to the second illumination system) travels through a first polarization setting unit 10 (second polarization setting unit 20) and a diffractive optical element 11 (21) to enter an afocal lens 12 (22). The diffractive optical element 11 (21) is arranged to be able to be set in or off an illumination optical path of the first illumination system (second illumination system) and is arranged to be replaceable with another diffractive optical element which forms a different light intensity distribution in its far field. The replacement of the diffractive optical element 11 (21) is performed by a driving unit (not shown) which operates based on a command from a control unit 5. For simplicity of description, it is assumed hereinafter that the diffractive optical element 11 arranged in the optical path of the first illumination system and the diffractive optical element 21 arranged in the optical path of the second illumination system both are diffractive optical elements for annular illumination.

The first polarization setting unit 10 (second polarization setting unit 20) has the following elements arranged in order from the light entrance side: quarter wave plate 10a (20a) which is so arranged that the crystal optic axis thereof is rotatable around the optical axis AX1 (AX2) and which converts elliptically polarized light incident thereto into linearly polarized light; half wave plate 10b (20b) which is so arranged that the crystal optic axis thereof is rotatable around the optical axis AX and which changes the polarization direction of linearly polarized light incident thereto; depolarizer (depolarization element) 10c (20c) which can be set in or off the illumination optical path. The first polarization setting unit 10 (second polarization setting unit 20) has such a function that, in a state in which the depolarizer 10c (20c) is set off the illumination optical path, it converts the light from the light source 1 into linearly polarized light with a desired polarization direction and makes the linearly polarized light incident to the diffractive optical element 11 (21) and, in a state in which the depolarizer 10c (20c) is set in the illumination optical path, it converts the light from the light source 1 into substantially unpolarized light and makes the unpolarized light incident to the diffractive optical element 11 (21). The first polarization setting unit 10 (second polarization setting unit 20) is controlled by a driving unit (not shown) which operates based on a command from the control unit 5. Concerning the detailed configuration and action of the polarization setting units, reference can be made, for example, to U.S. Pat. Published Application No. 2006/0055834.

The afocal lens 12 (22) is an afocal system (afocal optic) so set that a front focal point of a front lens unit 12a (22a) is approximately coincident with the position of the diffractive optical element 11 (21) and that a rear focal point of a rear lens unit 12b (22b) is approximately coincident with a position of a predetermined plane FP 1 (FP2) indicated by a dashed line in the drawing. In general, a diffractive optical element is made by forming level differences with a pitch nearly equal to the wavelength of the exposure light (illumination light) in a substrate and has an action to diffract an incident beam at desired angles.

Specifically, the diffractive optical element 11 (21) for annular illumination has such a function that when a parallel beam with a rectangular cross section is incident thereto, it forms an annular light intensity distribution in its far field (or Fraunhofer diffraction region). Therefore, a nearly parallel beam incident to the diffractive optical element 11 (21) forms an annular light intensity distribution on the pupil plane of the afocal lens 12 (22) and is then emitted in an annular angle distribution from the afocal lens 12 (22). In the optical path between the front lens unit 12a (22a) and the rear lens unit 12b (22b), an axicon system 13 (23) is located on or near the pupil plane of the afocal lens 12 (22). For simplicity of the description, it is assumed hereinafter that the axicon system 13 in the first illumination system and the axicon system 23 in the second illumination system both are conical axicon systems. The configuration and action of the conical axicon system 13 (23) will be described later.

The beam passing through the afocal lens 12 (22) travels through a zoom lens (power-varying optical system) 14 (24) for variation in σ value (σ value = mask-side numerical aperture of the illumination system/mask-side numerical aperture of the projection optical system) and is then incident into a micro fly's eye lens (or fly's eye lens) 15 (25). The micro fly's eye lens 15 (25) is an optical element consisting of a large number of micro lenses with a positive refracting power arrayed vertically and horizontally and densely. In general, a micro fly's eye lens is made, for example, by forming the micro lens group in a plane-parallel plate by etching.

Each micro lens forming the micro fly's eye lens is smaller than each lens element forming the fly's eye lens. In the micro fly's eye lens, different from the fly's eye lens consisting of lens elements isolated from each other, the large number of micro lenses (micro refracting faces) are integrally formed without being isolated from each other. However, the micro fly's eye lens is an optical integrator of the same wavefront division type as the fly's eye lens, in that the lens elements with positive refracting power are arranged vertically and horizontally.

The position of the predetermined plane FP1 (FP2) is located near the front focal point of the zoom lens 14 (24) and the entrance surface of the micro fly's eye lens 15 (25) is located near the rear focal point of the zoom lens 14 (24). In other words, the zoom lens 14 (24) establishes a substantial Fourier transform relation between the predetermined plane FP1 (FP2) and the entrance surface of the micro fly's eye lens 15 (25) and, therefore, keeps the pupil plane of the afocal lens 12 (22) approximately optically conjugate with the entrance surface of the micro fly's eye lens 15 (25).

Therefore, for example, an annular illumination field (annular light intensity distribution) centered on the optical axis AX1 (AX2) is formed on the entrance surface of the micro fly's eye lens 15 (25) as on the pupil plane of the afocal lens 12 (22). The overall shape of this annular illumination field similarly varies depending upon the focal length of the zoom lens 14 (24). Each micro lens forming the micro fly's eye lens 15 (25) has a rectangular cross section similar to the shape of the first illumination region (second illumination region) to be illuminated on the first mask M1 (second mask M2) (and, therefore, similar to the shape of an exposure region to be formed on the wafer W).

The beam incident into the micro fly's eye lens 15 (25) is two-dimensionally divided by the large number of micro lenses and forms a secondary light source with a light intensity distribution approximately identical with the illumination field formed by the incident beam, i.e., a secondary light source consisting of a substantial surface illuminant of an annular shape centered on the optical axis AX1 (AX2), on or near the rear focal plane of the micro fly's eye lens. Beams from the secondary light source formed on or near the rear focal plane of the micro fly's eye lens 15 (25) travel through a condenser optical system 16 (26) to superposedly illuminate a mask blind 17 (27).

In this way, a rectangular illumination field according to the shape and focal length of each micro lens forming the micro fly's eye lens 15 (25) is formed on the mask blind 17 (27) as an illumination field stop. Beams passing through a rectangular aperture (light transmitting portion) of the mask blind 17 (27) are subjected to a converging action of an imaging optical system 18 (28) and thereafter superposedly illuminate the first illumination region (second illumination region) on the first mask M1 (second mask M2) on which a predetermined pattern is formed. Namely, the imaging optical system 18 (28) forms an image of the rectangular aperture of the mask blind 17 (27) on the first mask M1 (second mask M2). The imaging optical system 18 (28) is composed of a front lens unit 18a (28a) and a rear lens unit 18b (28b) and a path folding mirror PM1 (PM2) is located between the two lens units 18a (28a) and 18b (28b). For clarity of the drawing, reference symbols 18, 28 are omitted from illustration.

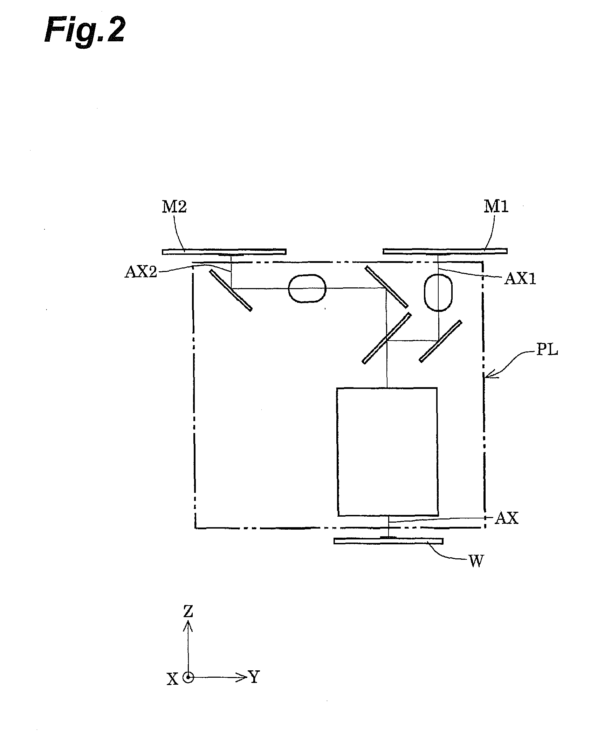

The first mask M1 is held on a first mask stage MS1 and the second mask M2 on a second mask stage MS2. More specifically, the second mask M2 is located with a spacing along the Y-direction from the first mask M1 and at the same height as the first mask M1 along the Z-direction. A first beam passing through the first illumination region on the first mask M1 and a second beam passing through the second illumination region on the second mask M2 travel through a so-called double-headed projection optical system PL to form a pattern image of the first mask M1 and a pattern image of the second mask M2 on the wafer (photosensitive substrate) W held on a wafer stage WS. The double-headed projection optical system PL is an optical system having two effective view fields spaced from each other, and one effective image region. The first embodiment, as schematically shown in Fig. 2, uses the double-headed projection optical system PL of a type which forms the pattern image of the first mask M1 and the pattern image of the second mask M2 in alignment on the wafer W by means of beam splitters.

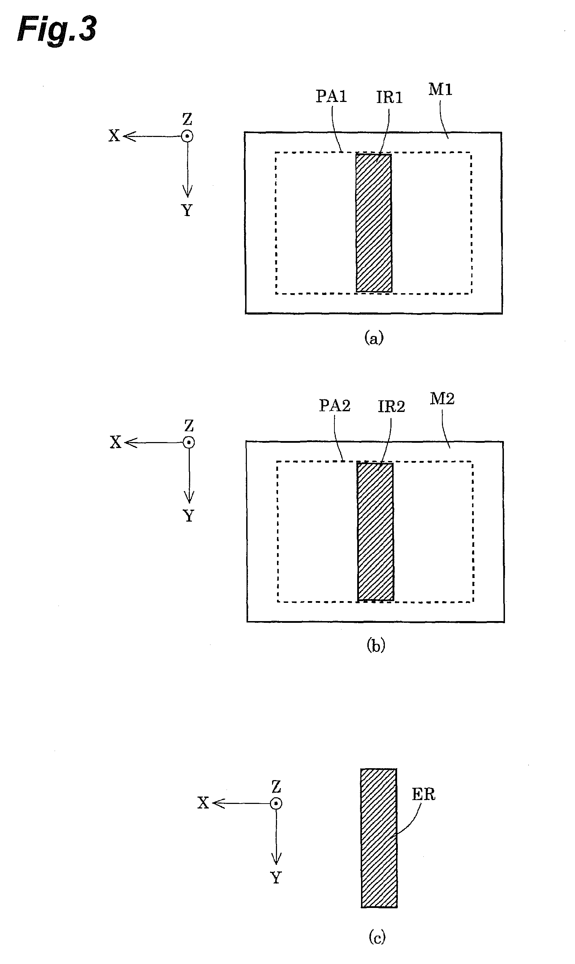

The first beam, which formed the annular light intensity distribution on the rear focal plane of the micro fly's eye lens 15 or on the illumination pupil (illumination pupil of the first illumination system) near it, forms the first illumination region IR1 of a rectangular shape elongated in the Y-direction on the first mask M1, as shown in Fig. 3 (a). The second beam, which formed the annular light intensity distribution on the rear focal plane of the micro fly's eye lens 25 or on the illumination pupil (illumination pupil of the second illumination system) near it, forms the second illumination region IR2 of a rectangular shape elongated in the Y-direction on the second mask M2, as shown in Fig. 3 (b). At this time, the first illumination system and the second illumination system illuminate the first illumination region IR1 and the second illumination region IR2 simultaneously.

Namely, a pattern corresponding to the first illumination region IR1 is annularly illuminated in a pattern region PA1 on the first mask M1, while a pattern corresponding to the second illumination region IR2 is annularly illuminated in a pattern region PA2 on the second mask M2. In this manner, as shown in Fig. 3 (c), the pattern image of the first mask M1 illuminated with the light from the first illumination region IR1 and the pattern image of the second mask M2 illuminated with the light from the second illumination region IR2 are formed in superposition in a rectangular effective image region ER of the projection optical system PL, i.e., in a rectangular region ER elongated in the Y-direction.

In the first embodiment, while the first mask M1, the second mask M2, and the wafer W are synchronously moved along the X-direction with respect to the projection optical system PL, one synthetic pattern is formed in one shot area on the wafer W by superimposed scanning exposures of the pattern of the first mask M1 and the pattern of the second mask M2. By two-dimensionally stepping the wafer W along the XY plane with respect to the projection optical system PL and repeating the above-described superimposed scanning exposures, the synthetic pattern of the pattern of the first mask M1 and the pattern of the second mask M2 is sequentially formed in each of shot areas on the wafer W.

The conical axicon system 13 (23) is composed of the following elements arranged in order from the light source side (light entrance side): first prism member 13a (23a) with a plane on the light source side and with a refracting surface of a concave conical shape on the mask side (light exit side); second prism member 13b (23b) with a plane on the mask side and with a refracting surface of a convex conical shape on the light source side. The concave conical refracting surface of the first prism member 13a (23a) and the convex conical refracting surface of the second prism member 13b (23b) are complementarily formed so as to be able to contact each other. At least one of the first prism member 13a (23a) and the second prism member 13b (23b) is arranged as movable along the optical axis AX1 (AX2) so that the spacing can be varied between the concave conical refracting surface of the first prism member 13a (23a) and the convex conical refracting surface of the second prism member 13b (23b). The variation in the spacing along the optical axis AX1 (AX2) between the first prism member 13a (23a) and the second prism member 13b (23b) in the conical axicon system 6 is implemented by a driving unit (not shown) which operates based on a command from the control unit 5.

The action of the conical axicon system 13 (23) and the action of the zoom lens 14 (24) will be described below with focus on the annular secondary light source. In a state in which the concave conical refracting surface of the first prism member 13a (23a) and the convex conical refracting surface of the second prism member 13b (23b) contact each other, the conical axicon system 13 (23) functions as a plane-parallel plate and causes no effect on the annular secondary light source formed. However, as separation is effected between the concave conical refracting surface of the first prism member 13 a (23a) and the convex conical refracting surface of the second prism member 13b (23b), the outside diameter (inside diameter) of the annular secondary light source varies while the width of the annular secondary light source (half of a difference between the outside diameter and the inside diameter of the annular secondary light source) is kept constant. Namely, the separation results in varying the annular ratio (inside diameter/outside diameter) and the size (outside diameter) of the annular secondary light source.

The zoom lens 14 (24) has a plurality of optical elements movable along the optical axis AX1 (AX2) and has a function to similarly (isotropically) enlarge or reduce the overall shape of the annular secondary light source. For example, when the focal length of the zoom lens 14 (24) is increased from a minimum value to a predetermined value, the overall shape of the annular secondary light source is similarly enlarged. In other words, the width and size (outside diameter) of the secondary light source both vary, without change in the annular ratio of the annular secondary light source, by virtue of the action of the zoom lens 14 (24). The focal length of the zoom lens 14 (24) is changed by a driving unit (not shown) which operates based on a command from the control unit 5. In this manner, the annular ratio and size (outside diameter) of the annular secondary light source can be controlled by the actions of the conical axicon system 13 (23) and the zoom lens 14 (24).

When another diffractive optical element for multi-pole illumination (not shown) is set instead of the diffractive optical element 11 (21) for annular illumination in the illumination optical path, multi-pole illumination (dipolar illumination, tripolar illumination, quadrupolar illumination, pentapolar illumination, or the like) can be implemented. Specifically, for example, the diffractive optical element for dipolar illumination (or for quadrupolar illumination) has such a function that when a parallel beam with a rectangular cross section is incident thereto, it forms a light intensity distribution of a dipolar shape (or quadrupolar shape) in its far field. Therefore, beams passing through the diffractive optical element for dipolar illumination (or for quadrupolar illumination) form, for example, an illumination field pattern of a dipolar shape (or quadrupolar shape) consisting of two (or four) illumination fields symmetric with respect to the optical axis AX, on the entrance surface of the micro fly's eye lens 15 (25). As a result, the secondary light source of the same dipolar shape (or quadrupolar shape) as the illumination field pattern formed on the entrance surface of the micro fly's eye lens is formed on or near the rear focal plane of the micro fly's eye lens 15 (25).

When a diffractive optical element for circular illumination (not shown) is set instead of the diffractive optical element 11 (21) for annular illumination in the illumination optical path, ordinary circular illumination can be implemented. The diffractive optical element for circular illumination has such a function that when a parallel beam with a rectangular cross section is incident thereto, it forms a circular light intensity distribution in its far field. Therefore, a beam passing through the diffractive optical element for circular illumination forms, for example, an illumination field of a circular shape centered on the optical axis AX, on the entrance surface of the micro fly's eye lens 15 (25). As a result, the secondary light source of the same circular shape as the illumination field formed on the entrance surface of the micro fly's eye lens is formed on or near the rear focal plane of the micro fly's eye lens 15 (25).

For example, in the case of the quadrupolar illumination, the control unit 5 sets a pyramid axicon system (not shown), instead of the conical axicon system 13 (23) (or in addition to the conical axicon system 13 (23)), on or near the pupil plane of the afocal lens 12 (22). For example, in the case of the dipolar illumination, the control unit 5 sets a V-groove axicon system (not shown), instead of the conical axicon system 13 (23) (or in addition to the conical axicon system 13 (23)), on or near the pupil plane of the afocal lens 12 (22). The pyramid axicon system has refracting surfaces of the shape corresponding to side faces of a pyramid centered on the optical axis, and the V-groove axicon system has refracting surfaces of a V-shaped cross section approximately symmetric with respect to a predetermined axis passing the optical axis. Concerning the configurations and actions of the pyramid axicon system and the V-groove axicon system, reference can be made, for example, to Japanese Patent Application Laid-open No. 2002-231619 and U.S. Pat. Published Application No. 2004/0263817 corresponding thereto.

In the first embodiment, the plurality of interchangeable diffractive optical elements including the diffractive optical element 11 constitute the first shape varying system which varies the shape of the light intensity distribution on the illumination pupil of the first illumination system, and the plurality of interchangeable diffractive optical elements including the diffractive optical element 21 constitute the second shape varying system which varies the shape of the light intensity distribution on the illumination pupil of the second illumination system. Similarly, the conical axicon system 13, the pyramid axicon system, and the V-groove axicon system constitute the first shape varying system which varies the shape of the light intensity distribution on the illumination pupil of the first illumination system, and the conical axicon system 23, the pyramid axicon system, and the V-groove axicon system constitute the second shape varying system which varies the shape of the light intensity distribution on the illumination pupil of the second illumination system. Furthermore, the zoom lens 14 constitutes the first power varying system which varies the size of the light intensity distribution on the illumination pupil of the first illumination system, and the zoom lens 24 constitutes the second power varying system which varies the size of the light intensity distribution on the illumination pupil of the second illumination system.

In the first embodiment, exposure information of the photosensitive substrate, i.e., information about various masks to be sequentially used for exposures according to the step-and-scan method, is fed through an input unit 6 like a keyboard to the control unit 5. Based on the information from the input unit 6, the control unit 5 independently controls the replacement and arrangement of the diffractive optical element in the first illumination system and the replacement and arrangement of the diffractive optical element in the second illumination system. In addition, based on the information from the input unit 6, the control unit 5 also independently controls the spacing adjustment of the axicon system in the first illumination system and the spacing adjustment of the axicon system in the second illumination system. Furthermore, based on the information from the input unit 6, the control unit 5 also independently controls the adjustment of the focal length of the zoom lens 14 in the first illumination system and the adjustment of the focal length of the zoom lens 24 in the second illumination system. In this manner, the first shape varying system and first power varying system and the second shape varying system and second power varying system vary the light intensity distribution on the illumination pupil of the first illumination system and the light intensity distribution on the illumination pupil of the second illumination system, independently of each other.

Yet furthermore, based on the information from the input unit 6, the control unit 5 independently controls the first polarization setting unit 10 which sets the polarization state of the light to illuminate the first illumination region IR1 on the first mask M1, to a desired polarization state and the second polarization setting unit 20 which sets the polarization state of the light to illuminate the second illumination region IR2 on the second mask M2, to a desired polarization state. In this manner, the first polarization setting unit 10 and the second polarization setting unit 20 vary the polarization state of the light to illuminate the first illumination region IR1 on the first mask M1 and the polarization state of the light to illuminate the second illumination region IR2 on the second mask M2, independently of each other.

As described above, the illumination optical apparatus of the first embodiment is able to individually illuminate the first illumination region IR1 on the first mask M1 and the second illumination region IR2 on the second mask M2, under required illumination conditions with the shape or size of the light intensity distribution on the illumination pupil, the polarization state of illumination light, or the like as a parameter.

Since in the exposure apparatus of the first embodiment the polarization setting units 10, 20 are arranged in the respective optical paths divided by the half mirror 3, the first illumination region IR1 on the first mask M1 and the second illumination region IR2 on the second mask M2 can be individually illuminated under optional polarization states even when there is a polarization characteristic of the half mirror 3 (e.g., such a characteristic that polarization states are different from each other between the beams divided by the half mirror 3). When a polarization beam splitter is used in place of the half mirror 3, this effect will appear prominent.

As a consequence, the exposure apparatus of the first embodiment is able to perform the exposures of the fine patterns of the two masks M1 and M2 with high accuracy and high throughput on the wafer W by the double exposure method, using the illumination optical apparatus individually illuminating the two illumination regions IR1 and IR2 spaced from each other, under the required illumination conditions.

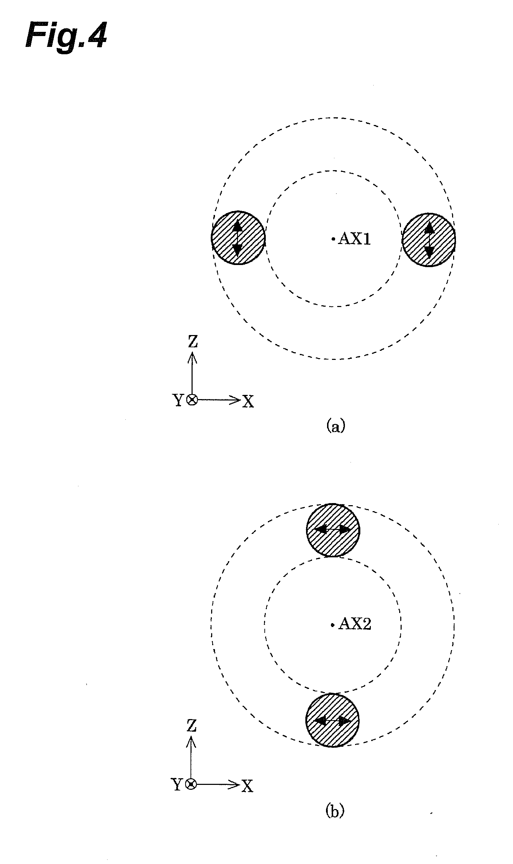

An example of the effect achieved based on the configuration of the first embodiment will be described below with reference to Fig. 4. It is preferable in the exposure apparatus of the first embodiment that each of the pattern of the first mask M1 and the pattern of the second mask M2 be illuminated with light in a required linearly polarized state so that the light impinging on the wafer W is in a polarization state in which the principal component thereof is s-polarized light. The s-polarized light herein is linearly polarized light with the polarization direction along a direction normal to a plane of incidence (i.e., polarized light with the electric vector vibrating in directions perpendicular to the plane of incidence). The plane of incidence is defined as a plane including a point where light reaches a boundary surface of a medium (the surface of wafer W) and including a normal to the boundary surface at that point and a direction of incidence of light. When the mask pattern is illuminated with the light in the required linearly polarized state so that the light impinging upon the wafer W is in the polarization state with the principal component of s-polarized light in this manner, an improvement can be made in optical performance (depth of focus or the like) of the projection optical system PL, whereby a high-contrast mask pattern image can be obtained on the wafer W.

Specifically, for example, when the pattern on the first mask M1 is dominated by a unidirectional pattern elongated along the Y-direction, X-directional dipolar illumination as shown in Fig. 4 (a) is implemented by the action of the diffractive optical element and others disposed in the first illumination system. By the action of the first polarization setting unit 10, the beams forming the secondary light source of the dipolar shape (beams passing through the secondary light source) formed with a spacing in the X-direction on both sides of the optical axis AX1 on the illumination pupil of the first illumination system are set in a linearly polarized state with the polarization direction along the Z-direction. As a result, the light impinging on the wafer W as a final illumination target surface becomes in the polarization state with the principal component of s-polarized light, whereby a high-contrast mask pattern image is obtained on the wafer W. Furthermore, without having to be limited to this, like effect is also achieved by forming the secondary light source of a relatively small circular shape centered on the optical axis AX1 on the illumination pupil of the first illumination system and setting the beam forming this circular secondary light source in the linearly polarized state with the polarization direction along the Z-direction.

Similarly, for example, when the pattern on the second mask M2 is dominated by a unidirectional pattern elongated along the X-direction, Z-directional dipolar illumination as shown in Fig. 4 (b) is implemented by the action of the diffractive optical element and others disposed in the second illumination system. By the action of the second polarization setting unit 20, the beams forming the secondary light source of the dipolar shape formed with a spacing in the Z-direction on both sides of the optical axis AX2 on the illumination pupil of the second illumination system are set in a linearly polarized state with the polarization direction along the X-direction. As a result, the light impinging on the wafer W becomes in the polarization state with the principal component of s-polarized light, whereby a high-contrast mask pattern image is obtained on the wafer W. Furthermore, without having to be limited to this, like effect is also achieved by forming the secondary light source of a relatively small circular shape centered on the optical axis AX2 on the illumination pupil of the second illumination system and setting the beam forming this circular secondary light source in the linearly polarized state with the polarization direction along the X-direction.

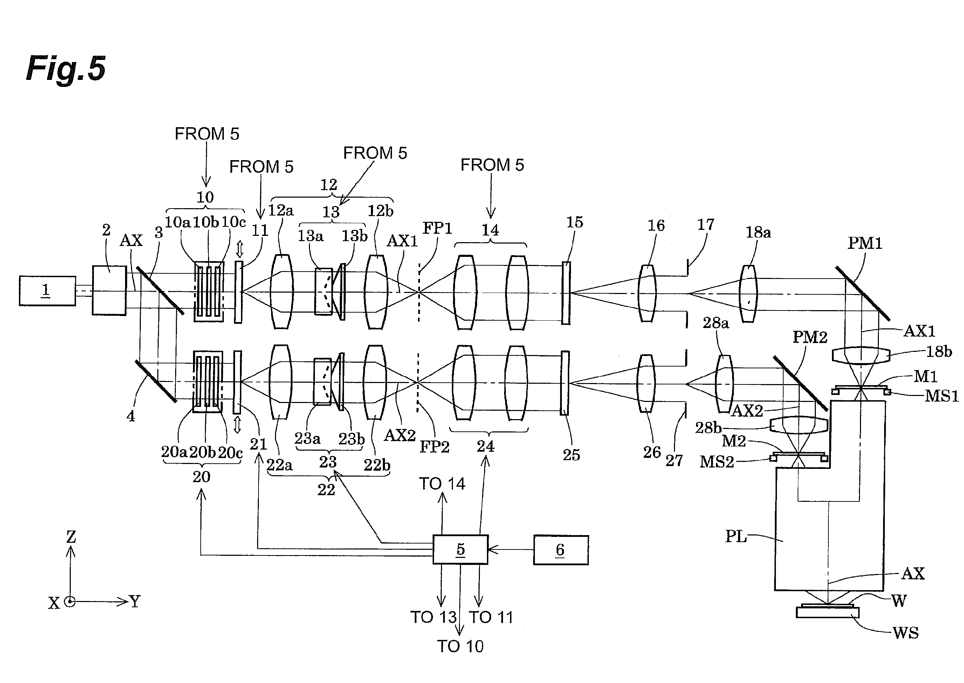

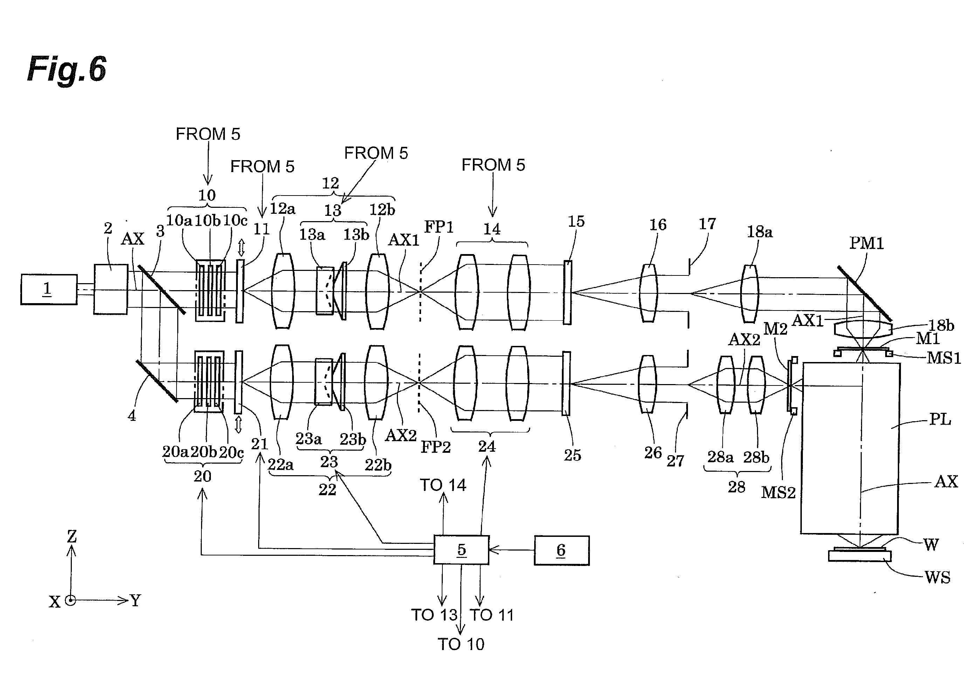

In the above-described first embodiment, the first mask M1 and the second mask M2 are located at the same height along the Z-direction. However, without having to be limited to this, it is also possible to locate the first mask M1 and the second mask M2 at mutually different heights along the Z-direction, as shown in a first modification example of Fig. 5. It is also possible to hold the second mask M2 along the XZ plane, without installation of the path folding mirror PM2 in the second illumination system, as shown in a second modification example of Fig. 6. In the first modification example of Fig. 5 and the second modification example of Fig. 6, it is easier to secure a space for arrangement of the two mask stages and a space for movement of the two mask stages during the scanning exposures, than in the first embodiment of Fig. 1.

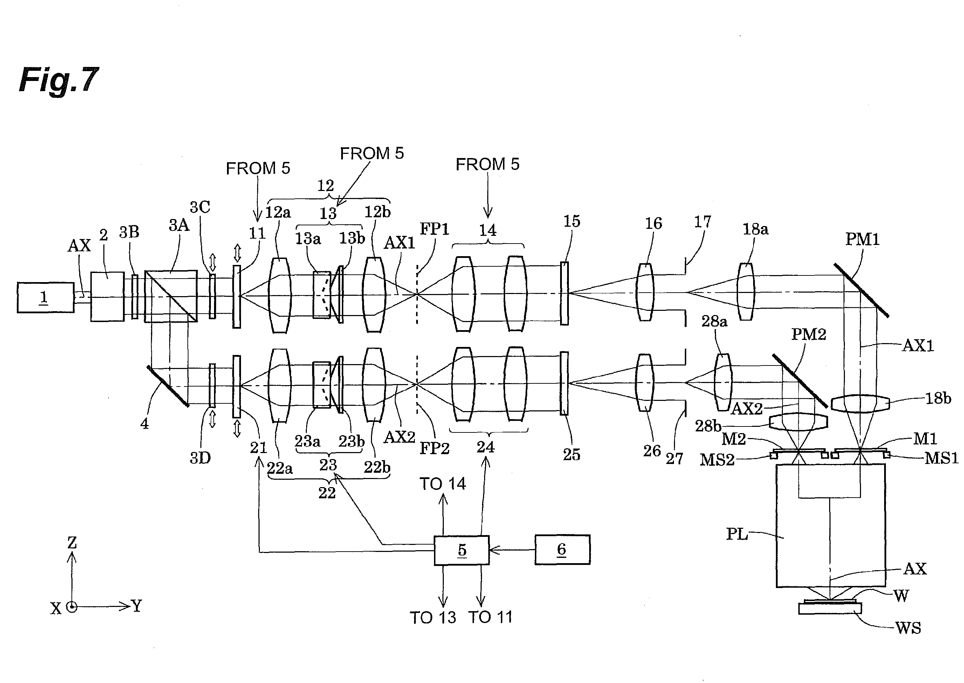

In the above-described first embodiment, the polarization state of the light to illuminate the first illumination region IR1 on the first mask M1 is set in the desired polarization state by the action of the first polarization setting unit 10 in the first illumination system, and the polarization state of the light to illuminate the second illumination region IR2 on the second mask M2 is set in the desired polarization state by the action of the second polarization setting unit 20 in the second illumination system. However, without having to be limited to this, it is also possible to adopt a modification example wherein a polarization beam splitter 3A is located instead of the half mirror 3 and wherein the installation of the first polarization setting unit 10 and the second polarization setting unit 20 is omitted, as shown in Fig. 7.

In the third modification example of Fig. 7, a depolarizer (depolarization element) 3B is fixedly arranged in the optical path between the polarization beam splitter 3A and the shaping optical system 2. Furthermore, depolarizers 3C and 3D are detachably arranged in the optical path between the polarization beam splitter 3A and the diffractive optical element 11 and in the optical path between the path folding mirror 4 and the diffractive optical element 21. Therefore, light substantially in an unpolarized state is incident to the polarization beam splitter 3A, p-polarized light (or light linearly polarized along Z-direction) transmitted by the polarization beam splitter 3A is guided to the first illumination system, and s-polarized light (or light linearly polarized along the X-direction) reflected by the polarization beam splitter 3A is guided to the second illumination system.

When the depolarizers 3C and 3D both are set off the illumination optical path, the first illumination region IR1 on the first mask M1 is illuminated with light in a linearly polarized state with the polarization direction along the Y-direction and the second illumination region IR2 on the second mask M2 is illuminated with light in a linearly polarized state with the polarization direction along the X-direction. When only the depolarizer 3C is set in the illumination optical path, the first illumination region IR1 is illuminated with the light in the unpolarized state and the second illumination region IR2 is illuminated with the light in the linearly polarized state with the polarization direction along the X-direction. When only the depolarizer 3D is set in the illumination optical path, the first illumination region IR1 is illuminated with the light in the linearly polarized state with the polarization direction along the Y-direction and the second illumination region IR2 is illuminated with the light in the unpolarized state. As a result, the first illumination region IR1 and the second illumination region IR2 are illuminated with the light beams in the mutually different polarization states and, therefore, the first illumination region IR1 and the second illumination region IR2 can be illuminated with light in their respective desired polarization states.

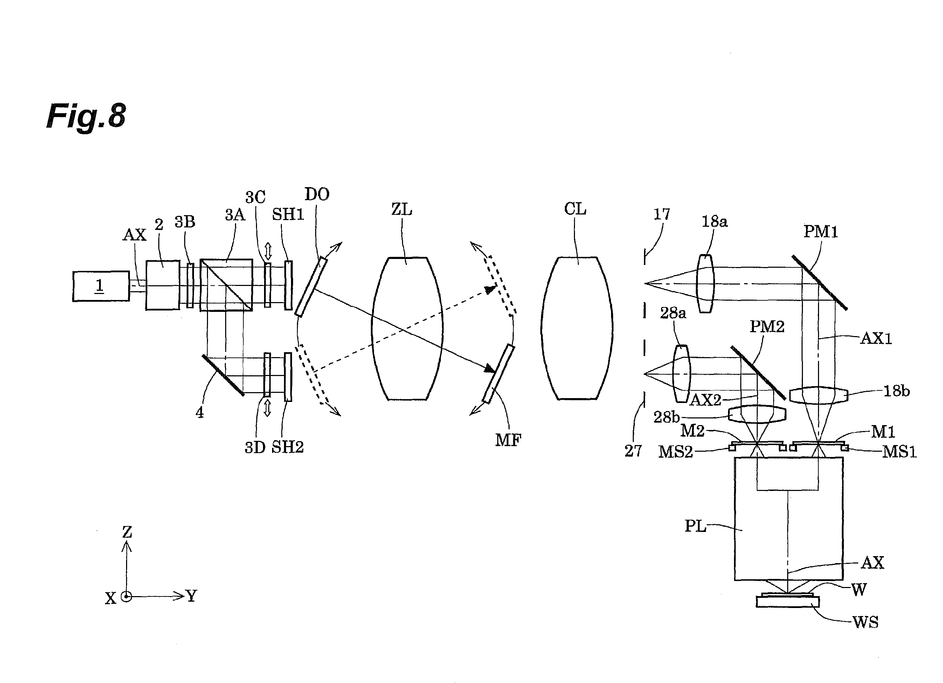

In the third modification example of Fig. 7, the diffractive optical element 11 and the micro fly's eye lens 15 are arranged in the first illumination system and the diffractive optical element 21 and the micro fly's eye lens 25 are arranged in the second illumination system. However, without having to be limited to this, it is also possible to adopt a configuration to implement switching between the illumination of the first illumination region IR1 and the illumination of the second illumination region IR2, by changing postures of a pair of one diffractive optical element DO and one micro fly's eye lens MF, for example, as shown in a fourth modification example of Fig. 8. The fourth modification example of Fig. 8 is similar to the third modification example of Fig. 7, but is different only in the configuration in the optical paths between the depolarizers 3C, 3D and the mask blinds 17, 27 from the third modification example of Fig. 7. Fig. 8 is depicted without illustration of the control unit 5 and the input unit 6, for clarity of the drawing.

In the fourth modification example of Fig. 8, a first shutter SH1 is provided immediately after the position of insertion of the depolarizer 3C and a second shutter SH2 immediately after the position of insertion of the depolarizer 3D The first shutter SH1 and the second shutter SH2 have a function to shut out a beam incident along the optical path, as occasion demands. In the optical path between the shutters SH1, SH2 and the mask blinds 17, 27, there are the diffractive optical element DO, a common power-varying optical system ZL, the micro fly's eye lens MF, and a common condenser optical system CL arranged in order from the light source side. The diffractive optical element DO is an optical member corresponding to the diffractive optical element 11 or 21 in Fig. 7 and the micro fly's eye lens MF is an optical member corresponding to the micro fly's eye lens 15 or 25 in Fig. 7.

The common power-varying optical system ZL is an optical member corresponding to the zoom lenses 14, 24 in Fig. 7 and the common condenser optical system CL is an optical member corresponding to the condenser optical systems 16, 26 in Fig. 7. As described above, the pair of diffractive optical element DO and micro fly's eye lens MF are configured to be switchable between a first posture indicated by a solid line in the drawing and a second posture indicated by a dashed line in the drawing, by action of a swinging mechanism not shown. When the pair of diffractive optical element DO and micro fly's eye lens MF are set in the first posture, the light transmitted by the polarization beam splitter 3A passes through the first shutter SH1 and travels through the diffractive optical element DO, common power-varying optical system ZL, micro fly's eye lens MF, common condenser optical system CL, mask blind 27, etc. to illuminate the second illumination region IR2 on the second mask M2. At this time, the second shutter SH2 blocks passage of light to avoid occurrence of harmful light.

On the other hand, when the pair of diffractive optical element DO and micro fly's eye lens MF are set in the second posture, the light reflected by the polarization beam splitter 3A passes through the second shutter SH2 and then travels through the diffractive optical element DO, common power-varying optical system ZL, micro fly's eye lens MF, common condenser optical system CL, mask blind 17, etc. to illuminate the first illumination region IR1 on the first mask M1. At this time, the first shutter SH1 blocks passage of light to avoid occurrence of harmful light.

In the fourth modification example of Fig. 8, the first illumination optical path extending from the polarization beam splitter 3A via the shutter SH1 up to the second illumination region IR2 on the second mask MS2 and the second illumination optical path extending from the polarization beam splitter 3A via the shutter SH2 up to the first illumination region IR1 on the first mask MS1 are temporally separated in part thereof (diffractive optical element DO, common power-varying optical system ZL, micro fly's eye lens MF, and common condenser optical system CL).

In the fourth modification example of Fig. 8, as described above, the first illumination region IR1 and the second illumination region IR2 cannot be illuminated simultaneously, but the first illumination region IR1 and the second illumination region IR2 can be illuminated with the light in the mutually different polarization states as in the third modification example of Fig. 7.

It is also possible to apply the major configuration of the fourth modification example of Fig. 8, i.e., the configuration from the shutters SH1, SH2 to the common condenser optical system CL, for example, to the first embodiment of Fig. 1, the first modification example of Fig. 5, and the second modification example of Fig. 6. It is also possible to apply to the third modification example of Fig. 7 and the fourth modification example of Fig. 8, the configuration wherein the first mask M1 and the second mask M2 are located at mutually different heights along the Z-direction as shown in the first modification example of Fig. 5 or the configuration wherein the second mask M2 is held along the XZ plane as shown in the second modification example of Fig. 6.

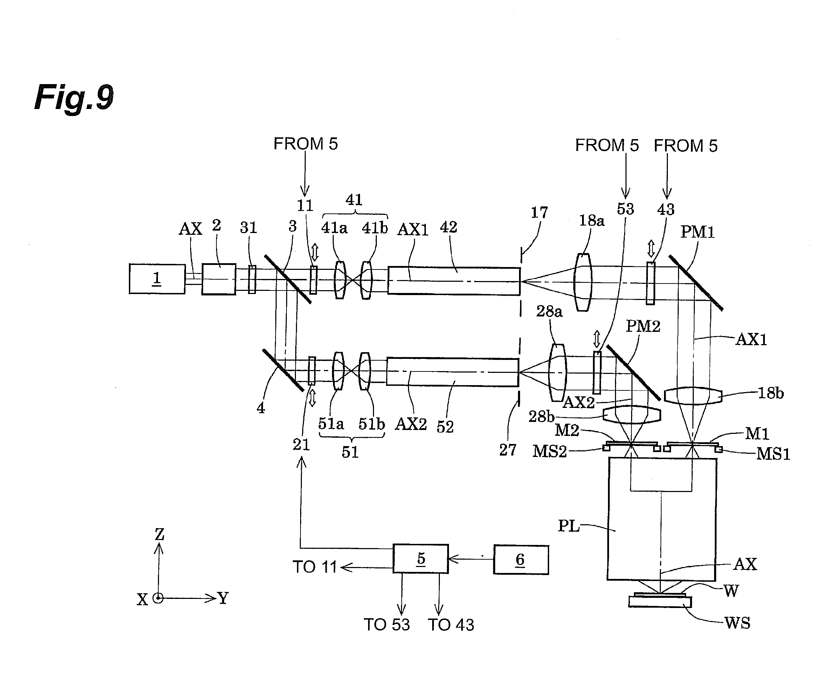

Fig. 9 is a drawing schematically showing a configuration of an exposure apparatus according to the second embodiment of the present invention. The second embodiment has a configuration similar to that of the first embodiment of Fig. 1, but is basically different in use of rod integrators of an internal reflection type as optical integrators for uniformizing the illuminance on the illumination target surface, from the first embodiment. In Fig. 9, elements with the same functionality as the components in the first embodiment of Fig. 1 are denoted by the same reference symbols as those in Fig. 1. The configuration and action of the second embodiment will be described below with focus on the difference from the first embodiment.

In the second embodiment of Fig. 9, rod integrators 42, 52 as optical integrators of the internal reflection type are arranged instead of the micro fly's eye lenses 15, 25 as the optical integrators of the wavefront division type in the first embodiment. In association with the installation of the rod integrators 41, 51, a depolarizer 31 is located in the optical path between the shaping optical system 2 and the half mirror 3 and the arrangement of the polarization setting units 10, 20, the afocal lenses 12, 22, the zoom lenses 14, 24, and the condenser optical systems 16, 26 is omitted. Furthermore, a first polarizing plate 42 is arranged so as to be able to be set in or off the optical path between the front lens unit 18a and the rear lens unit 18b of the imaging optical system 18 in the first illumination system and a second polarizing plate 52 is arranged so as to be able to be set in or off the optical path between the front lens unit 28a and the rear lens unit 28b of the imaging optical system 28 in the second illumination system. The first polarizing plate 42 and the second polarizing plate 52 are set in or off the respective illumination optical paths by a driving unit (not shown) which operates based on a command from the control unit 5.

In the second embodiment, the light from the light source 1 is converted into a required sectional shape by the shaping optical system 2, the light is then converted into light in an unpolarized state by the depolarizer 31, and thereafter the unpolarized light is incident to the half mirror 3. The light transmitted by the half mirror 3 is guided to the first illumination system and then travels through the diffractive optical element 11 and afocal lens 41 to enter the rod integrator 42. On the other hand, the light reflected by the half mirror 3 is reflected by the path folding mirror 4 to be guided to the second illumination system, and the light travels through the diffractive optical element 21 and afocal lens 51 to enter the rod integrator 52. The afocal lens 41 (51) has a front lens unit 41a (51a) and a rear lens unit 41b (51b). The rear focal point of the front lens unit 41 a (51 a) is approximately coincident with the front focal point of the rear lens unit 41b (51b) and the front lens unit 4 1 a (51a) and the rear lens unit 41b (51b) constitute an afocal optical system as a whole.

The rod integrators 42, 52 are rods of the internal reflection type made of an optical material, for example, like silica or fluorite and form light source images as many as the number of internal reflections along a plane passing a converging point and being parallel to the entrance surface of the rod by making use of total reflections on the boundary surface between the inside and the outside, i.e., the internal surface. Most of the light source images formed are virtual images, but only the light source image at the center (converging point) is a real image. Namely, the beam incident into the rod integrator 42, 52 is divided in angle directions by internal reflections to form a secondary light source consisting of a large number of light source images along the plane passing the converging point and being parallel to the entrance surface of the rod integrator. Beams from the secondary light source formed on the entrance side by the rod integrator 42, 52 are superposed on the exit surface thereof and then are incident to the imaging optical system 18, 28.

Namely, the beams from the rod integrator 42 in the first illumination system travel through the imaging optical system 18 to illuminate the first illumination region IR1 on the first mask M1. When the first polarizing plate 42 is inserted in the optical path between the front lens unit 18a and the rear lens unit 18b of the imaging optical system 18, for example, only the light in the linearly polarized state with the polarization direction along the Z-direction passes through the first polarizing plate 42 and the first illumination region IR1 is illuminated with the light in the linearly polarized state with the polarization direction along the Y-direction. On the other hand, when the first polarizing plate 42 is retracted from the optical path of the imaging optical system 18, the first illumination region IR1 is illuminated with the light in the unpolarized state.

Similarly, the beams from the rod integrator 52 in the second illumination system travel through the imaging optical system 28 to illuminate the second illumination region IR2 on the second mask M2. When the second polarizing plate 52 is inserted in the optical path between the front lens unit 28a and the rear lens unit 28b of the imaging optical system 28, for example, only the light in the linearly polarized state with the polarization direction along the X-direction passes through the second polarizing plate 52 and the second illumination region IR2 is illuminated with the light in the linearly polarized state with the polarization direction along the X-direction. On the other hand, when the second polarizing plate 52 is retracted from the optical path of the imaging optical system 28, the second illumination region IR2 is illuminated with the light in the unpolarized state.

The illumination optical apparatus of the second embodiment is also able to individually illuminate the first illumination region IR1 and the second illumination region IR2 under the required illumination conditions with the shape or size of the light intensity distribution on the illumination pupil, the polarization state of illumination light, or the like as a parameter, as in the first embodiment. When the aforementioned axicon system (conical axicon system, pyramid axicon system, V-groove axicon system, or the like) is arranged in the optical path of the front lens unit 41a (51a), the shape of the light intensity distribution formed on the illumination pupil of the first illumination system (second illumination system) can be varied. When the afocal lens 41 (51) is constructed as an afocal zoom lens, the size of the light intensity distribution formed on the illumination pupil of the first illumination system (second illumination system) can be varied.

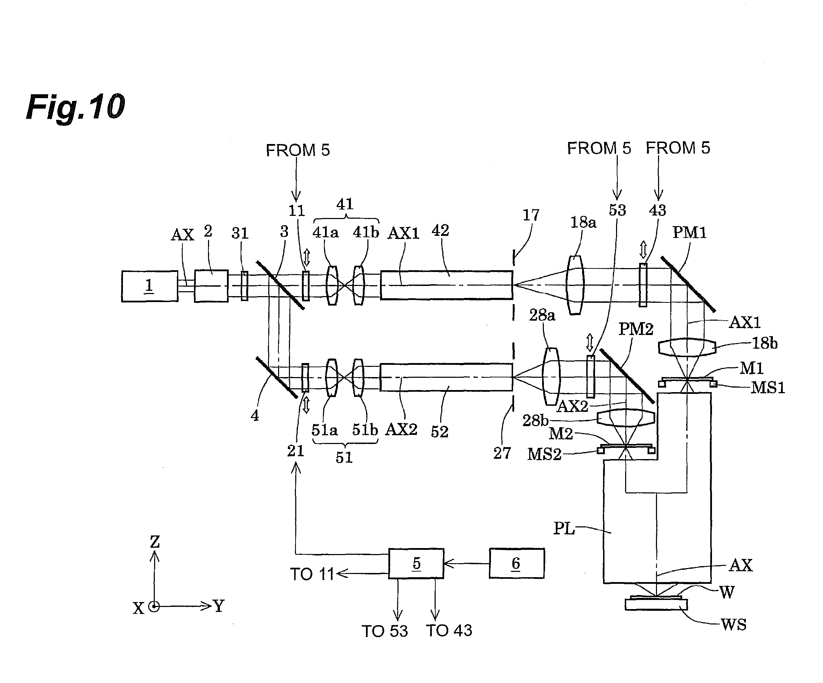

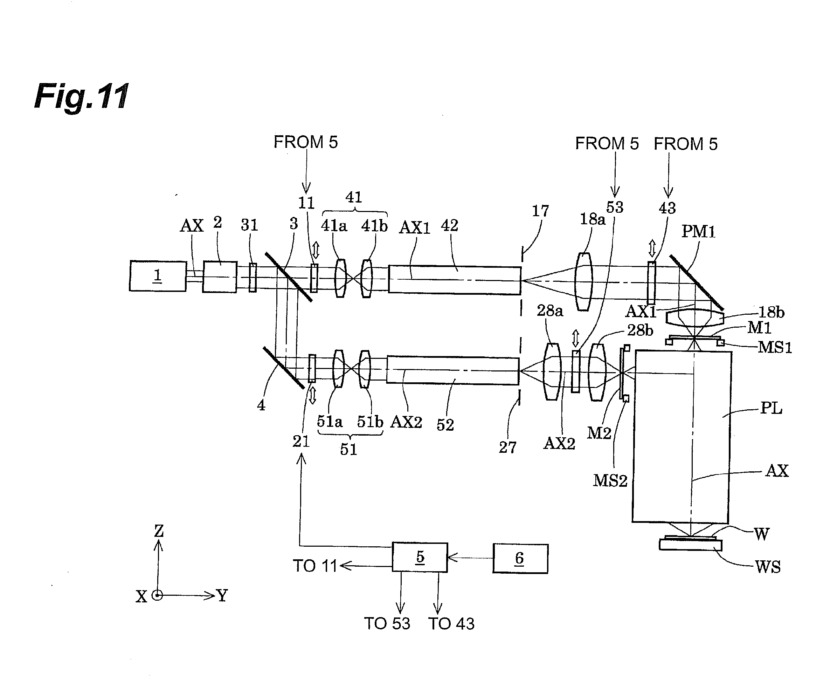

In the above-described second embodiment, the first mask M1 and the second mask M2 are located at the same height along the Z-direction. However, without having to be limited to this, the first mask M1 and the second mask M2 can also be located at mutually different heights along the Z-direction, as shown in a fifth modification example of Fig. 10. It is also possible to hold the second mask M2 along the XZ plane, without installation of the path folding mirror PM2 in the second illumination system, as shown in a sixth modification example of Fig. 11. In the fifth modification example of Fig. 10 and the sixth modification example of Fig. 11, it is easier to secure a space for arrangement of the two mask stages and a space for movement of the two mask stages during scanning exposures, than in the second embodiment of Fig. 9.

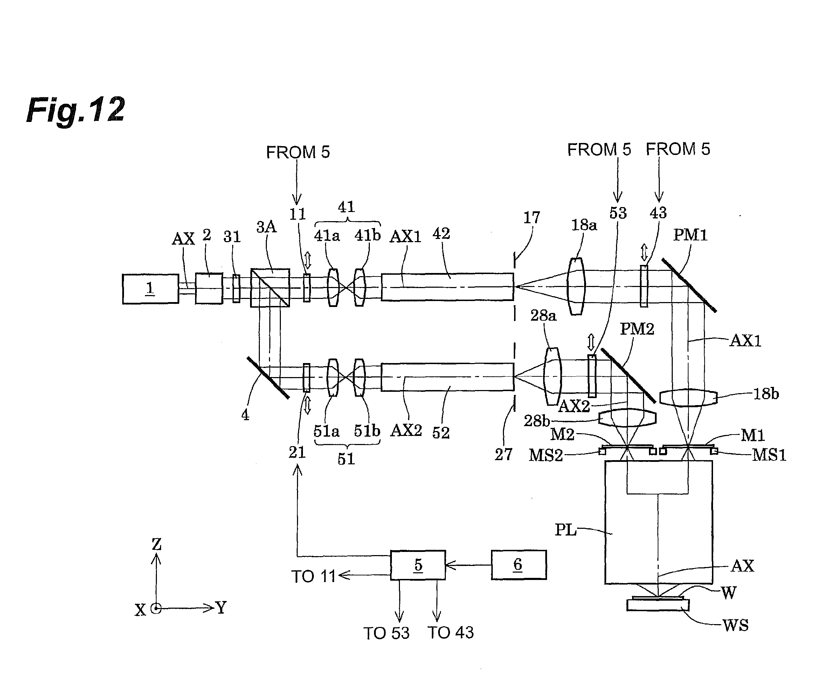

In the above-described second embodiment, the half mirror 3 is used as a light splitting member, the light from the common light source 1 is split into two beams by the half mirror 3, one of the split beams is guided to the first illumination system, and the other split light is guided to the second illumination system. However, without having to be limited to this, it is also possible to adopt a modification example wherein a polarization beam splitter 3A is arranged in place of the half mirror 3, as shown in Fig. 12. In the seventh modification example of Fig. 12, the light transmitted by the polarization beam splitter 3A is guided to the first illumination system and the light reflected by the polarization beam splitter 3A and reflected by the path folding mirror 4 is guided to the second illumination system. In the seventh modification example of Fig. 12, it is also possible to apply the configuration wherein the first mask M1 and the second mask M2 are arranged at mutually different heights along the Z-direction as shown in the fifth modification example of Fig. 10, or the configuration wherein the second mask M2 is held along the XZ plane as shown in the sixth modification example of Fig. 11.

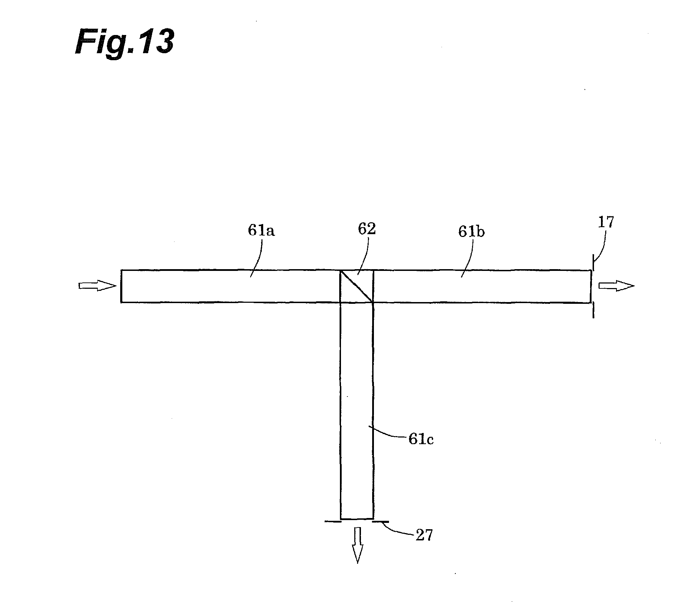

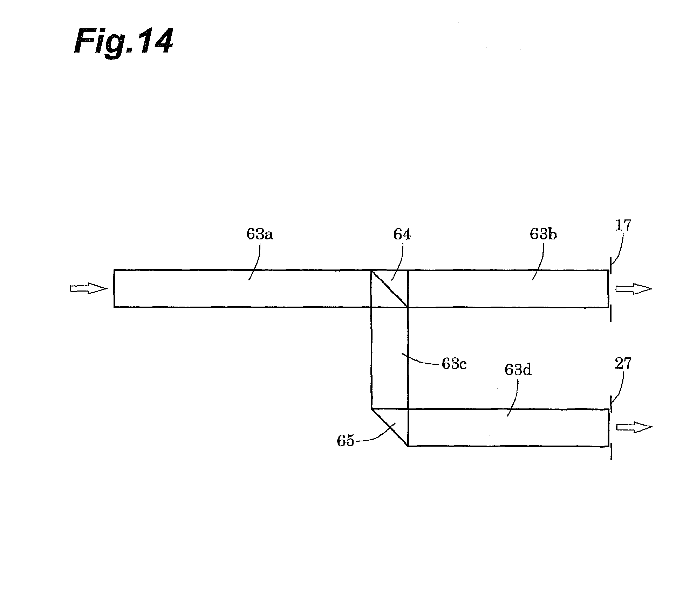

In the above-described second embodiment, one rod integrator 42 is arranged in the first illumination system and one rod integrator 52 in the second illumination system. In other words, the light beam from the common light source 1 is split before the rod integrators 42, 52, one of the split beams is made incident to one rod integrator 42, and the other split beam is made incident to the other rod integrator 52. However, without having to be limited to this, it is also possible to implement the splitting of the beam in a rod integrator by a combination of three rods 61a, 61b, 61c and a polarization beam splitter 62 as shown in an eighth modification example of Fig. 13, or to implement the splitting of the beam in a rod integrator by a combination of four rods 63a, 63b, 63c, 63d, a prism-type half mirror 64, and a right-angle prism 65 as shown in a ninth modification example of Fig. 14.

In the eighth modification example of Fig. 13, the light having passed, for example, through an optical system corresponding to the afocal lens 41 or 51 in Fig. 9 and having entered the rod 61 a, propagates inside the rod 61a and thereafter enters the polarization beam splitter 62. The light transmitted by the polarization beam splitter 62 propagates inside the rod 61b and is emitted through the mask blind 17. The light reflected by the polarization beam splitter 62 propagates inside the rod 61c and is emitted through the mask blind 27. Namely, the rod 61a and the rod 61b constitute the rod integrator in the first illumination system and the rod 61a and the rod 61 c constitute the rod integrator in the second illumination system.

In the ninth modification example of Fig. 14, the light having passed, for example, through an optical system corresponding to the afocal lens 41 or 51 in Fig. 9 and having entered the rod 63a, propagates inside the rod 63a and thereafter enters the prism-type half mirror 64. The light transmitted by the prism-type half mirror 64 propagates inside the rod 63b and then is emitted through the mask blind 17. The light reflected by the prism-type half mirror 64 propagates inside the rod 63c, is reflected by the right-angle prism 65, propagates inside the rod 63d, and is then emitted through the mask blind 27. Namely, the rod 63a and the rod 63b constitute the rod integrator in the first illumination system and the rod 63 a, the rod 63 c, and the rod 63d constitute the rod integrator in the second illumination system.

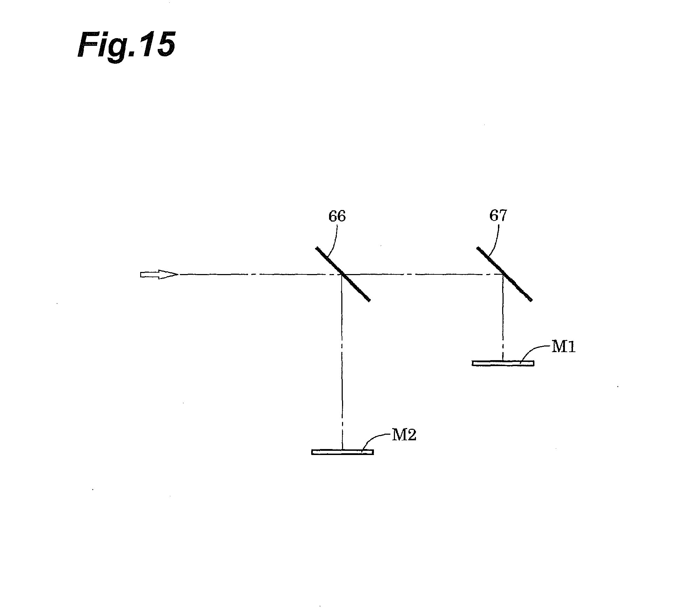

The above-described first embodiment and second embodiment adopt the configuration wherein the beam incident along the optical path of the first illumination system is reflected by the path folding mirror PM1 to be guided to the first mask M1 and wherein the beam incident along the optical path of the second illumination system independent of the first illumination system is reflected by the path folding mirror PM2 to be guided to the second mask M2. However, without having to be limited to this, it is also possible to adopt a configuration wherein a beam incident along a common optical path is split by a half mirror 66, light transmitted by the half mirror 66 is reflected by a path folding mirror 67 to be guided to the first mask M1, and light reflected by the half mirror 66 is guided to the second mask M2, as shown in a tenth modification example of Fig. 15. In this case, the first mask M1 and the second mask M2 can be located at mutually different heights as shown in Fig. 15, or the first mask M1 and the second mask M2 can be located at the same height.

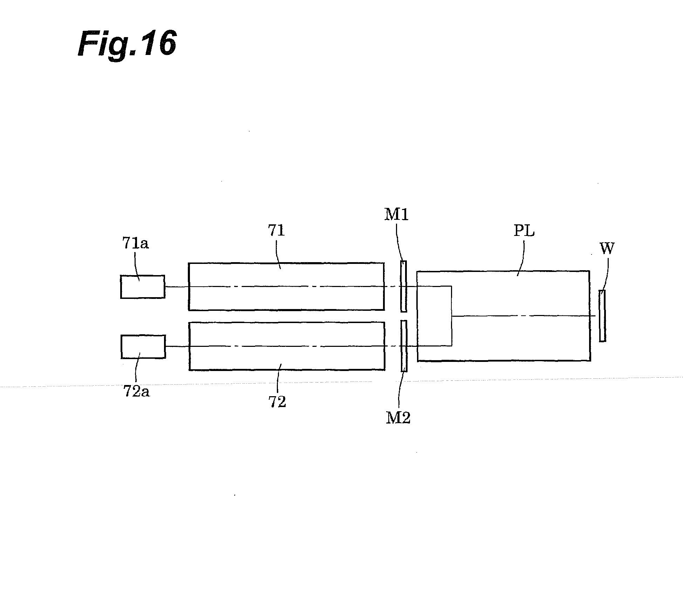

Incidentally, when coherency is high between two types of illumination states during simultaneous execution of double exposures, the pattern formed on the wafer is likely to be affected by interference of light. Therefore, the temporal coherency of the double exposures can be reduced by adopting a configuration as shown in an eleventh modification example of Fig. 16 wherein laser light sources 71a and 72a are set for the first illumination system 71 and for the second illumination system 72, respectively, and wherein timings of pulse emissions are temporally differentiated between the laser light sources 71a and 72a, thereby temporally separating the first illumination optical path of the first illumination system 71 and the second illumination optical path of the second illumination system 72. This configuration eventually permits the patterns of the masks M1, M2 to be formed well on the wafer W through the projection optical system PL.

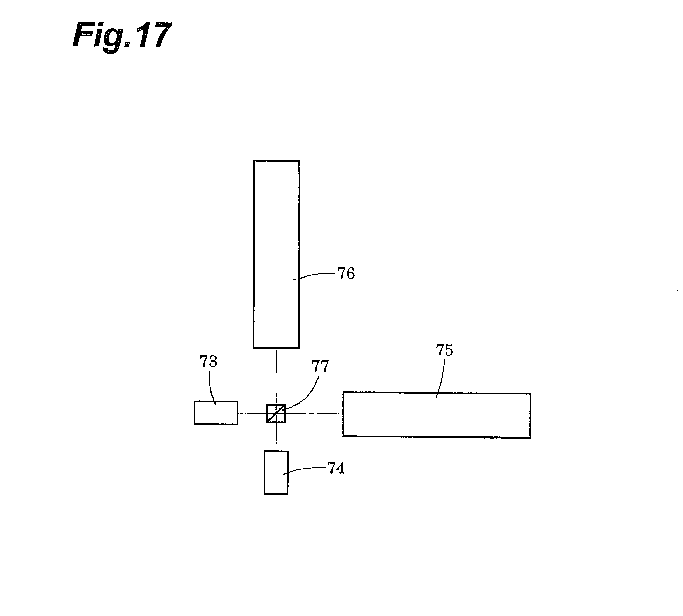

In a case where two laser light sources 73, 74 with mutually different polarization directions of emitted light and two exposure device bodies 75, 76 are combined through a half mirror 77 as in a twelfth modification example of Fig. 17, the temporal coherency can also be reduced between the two illumination light beams by temporally differentiating the timings of the pulse emissions between the laser light sources 73 and 74. In the twelfth modification example of Fig. 17, for example, p-polarized light emitted from the laser light source 73 is incident to the half mirror 77 and s-polarized light emitted from the laser light source 74 is incident to the half mirror 77. The p-polarized light from the laser light source 73 transmitted by the half mirror 77 and the s-polarized light from the laser light source 74 reflected by the half mirror 77 is incident into the exposure device body 75 and the p-polarized light from the laser light source 73 reflected by the half mirror 77 and the s-polarized light from the laser light source 74 transmitted by the half mirror 77 is incident into the exposure device body 76. In the eleventh modification example of Fig. 16 and the twelfth modification example of Fig. 17, control units in the respective exposure device bodies may be arranged to send trigger signals for determining the timings of the pulse emissions of the laser light sources 71 a, 72a and 73, 74, to the respective laser light sources 71a, 72a and 73, 74.

In each of the above-described embodiments, the present invention was explained in association with the double exposures to form one synthetic pattern by superimposing two types of patterns in a single shot area on the photosensitive substrate (wafer). However, without having to be limited to this, the present invention can also be applied similarly to multiple exposures to form one synthetic pattern by superimposing three or more types of patterns in a single shot area on the photosensitive substrate. In each of the above embodiments, one synthetic pattern is formed by the scanning exposures of the first pattern and the second pattern in the superimposed state in one shot area on the photosensitive substrate. However, without having to be limited to this, it is also possible to adopt a method of performing a scanning exposure or one-shot exposure of the first pattern in a first shot area on the photosensitive substrate and then performing a scanning exposure or one-shot exposure of the second pattern in a second shot area on the photosensitive substrate.

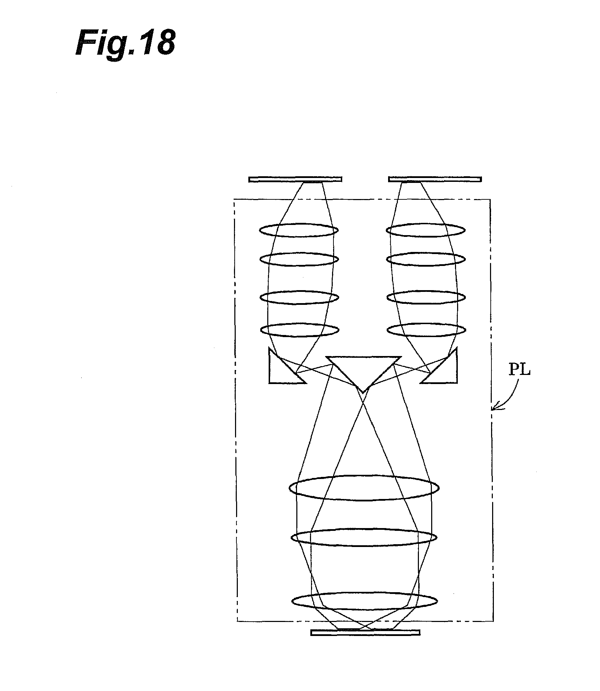

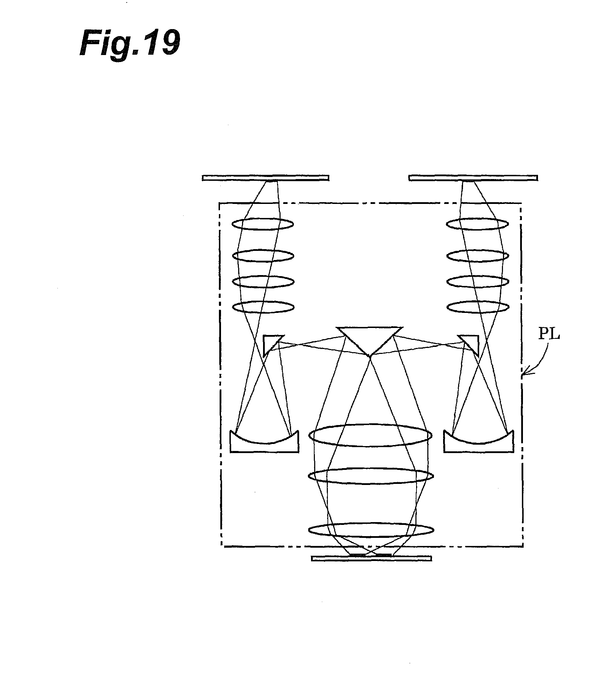

In each of the above embodiments, the pattern image of the first illumination region of the first mask and the pattern image of the second illumination region of the second mask are formed on the photosensitive substrate. However, without having to be limited to this, it is also possible to form pattern images of two illumination regions of a single mask on the photosensitive substrate. In each of the above embodiments, the pattern image of the first illumination region of the first mask and the pattern image of the second illumination region of the second mask are formed in alignment on the photosensitive substrate. However, without having to be limited to it, it is also possible to form the pattern image of the first illumination region of the first mask and the pattern image of the second illumination region of the second mask in parallel on the photosensitive substrate. In this case, the projection optical system PL applicable can be, for example, a double-headed projection optical system PL of another type consisting of a refracting system and folding mirrors as shown in Fig. 18, or a catadioptric double-headed projection optical system PL as shown in Fig. 19. Such double-headed projection optical systems applicable herein can be the optical systems proposed in U.S. Pat. Provisional Application No. 60/907,828.

In the aforementioned embodiments, the masks can be replaced with a pattern forming device that forms a predetermined pattern based on predetermined electronic data. Use of this pattern forming device minimizes the effect on synchronization accuracy even when the pattern surface is vertical. The pattern forming device applicable herein can be, for example, a DMD (Digital Micromirror Device) including a plurality of reflective elements driven based on predetermined electronic data. The exposure apparatus with the DMD is disclosed, for example, in Japanese Patent Applications Laid-open No. 8-313842 and Laid-open No. 2004-304135. Besides the non-emission type reflective spatial optical modulators like the DMD, it is also possible to use a transmissive spatial optical modulator or a self-emission type image display device.

In the foregoing embodiments, it is also possible to apply a technique of filling the optical path between the projection optical system and the photosensitive substrate with a medium having the refractive index larger than 1.1 (typically, a liquid), so called a liquid immersion method. In this case, one of the following methods can be adopted as the technique of filling the optical path between the projection optical system and the photosensitive substrate with the liquid: the technique of locally filling the optical path with the liquid as disclosed in International Publication WO99/49504; the technique of holding the substrate as an object to be exposed, by a stage and moving the stage in a liquid bath as disclosed in Japanese Patent Application Laid-open No. 6-124873; the technique of forming a liquid bath of a predetermined depth on a stage and holding the substrate in the bath as disclosed in Japanese Patent Application Laid-open No. 10-303114.

The exposure apparatus of the foregoing embodiments are manufactured by assembling various sub-systems containing their respective components as set forth in the scope of claims in the present application, so as to maintain predetermined mechanical accuracy, electrical accuracy, and optical accuracy. For ensuring these various accuracies, the following adjustments are carried out before and after the assembling: adjustment for achieving the optical accuracy for various optical systems; adjustment for achieving the mechanical accuracy for various mechanical systems; adjustment for achieving the electrical accuracy for various electrical systems. The assembling steps from the various sub-systems into the exposure apparatus include mechanical connections, wire connections of electric circuits, pipe connections of pneumatic circuits, etc. between the various sub-systems. It is needless to mention that there are assembling steps of the individual sub-systems, before the assembling steps from the various sub-systems into the exposure apparatus. After completion of the assembling steps from the various sub-systems into the exposure apparatus, overall adjustment is carried out to ensure various accuracies as the entire exposure apparatus. The manufacture of exposure apparatus is desirably performed in a clean room in which the temperature, cleanliness, etc. are controlled.

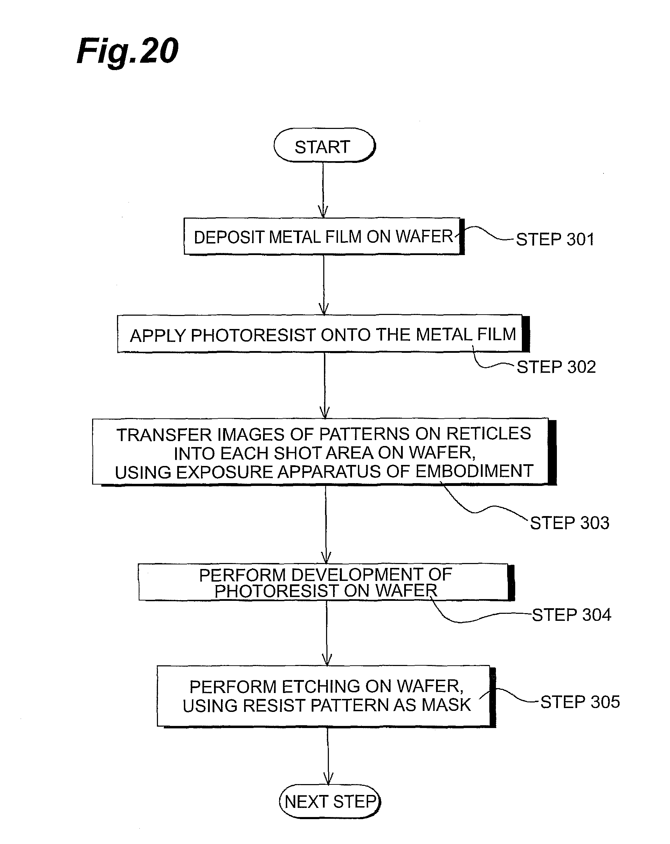

The exposure apparatus according to the above-described embodiments can be used to manufacture micro devices (semiconductor devices, imaging devices, liquid-crystal display devices, thin-film magnetic heads, etc.) through a process of illuminating masks (reticles) by the illumination optical apparatus (illumination step) and effecting exposures of transfer patterns formed on the masks, on a photosensitive substrate by use of the projection optical system (exposure step). The below will describe an example of a method of manufacturing semiconductor devices as micro devices by forming a predetermined circuit pattern on a wafer or the like as a photosensitive substrate by means of the exposure apparatus of the above embodiments, with reference to the flowchart of Fig. 20.

The first step 301 in Fig. 20 is to deposit a metal film on each wafer in one lot. The next step 302 is to apply a photoresist onto the metal film on each wafer in the lot. The subsequent step 303 is to use the exposure apparatus of the embodiments to sequentially transfer images of patterns on masks into each shot area on each wafer in the lot through the projection optical system of the exposure apparatus. The subsequent step 304 is to perform development of the photoresist on each wafer in the lot and the next step 305 is to perform etching using the resist pattern as a mask on each wafer in the lot, and thereby to form a circuit pattern corresponding to the patterns on the masks, in each shot area on each wafer.

Thereafter, devices such as semiconductor devices are manufactured through steps including formation of circuit patterns in upper layers. The above-described semiconductor device manufacturing method permits us to obtain the semiconductor devices with extremely fine circuit patterns at high throughput. The steps 301-305 are arranged to perform the respective steps of deposition of metal on the wafer, application of the resist onto the metal film, exposure, development, and etching, but it is needless to mention that the process may be modified as follows: prior to these steps, an oxide film of silicon is formed on the wafer, a resist is then applied onto the silicon oxide film, and thereafter the steps of exposure, development, and etching are carried out.

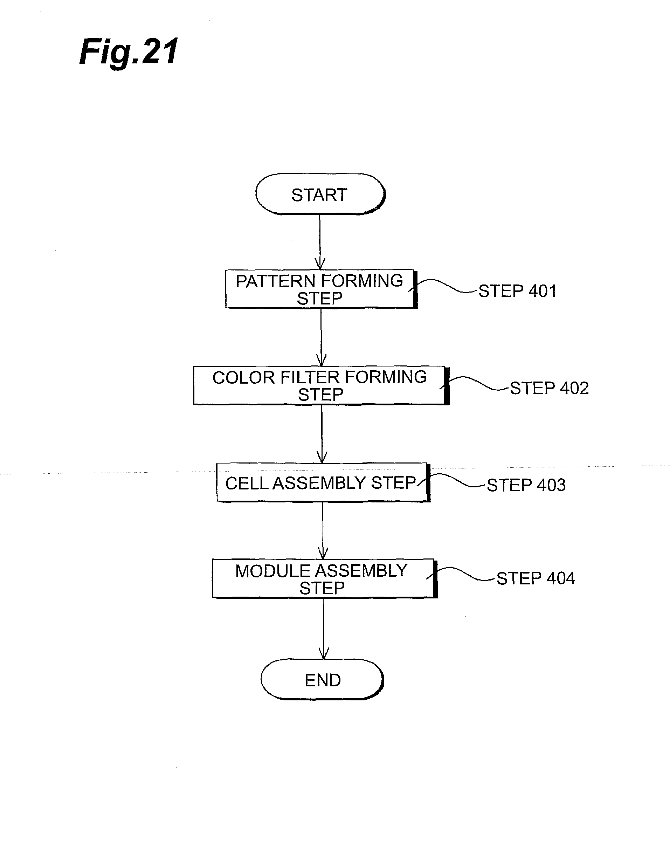

The exposure apparatus of the above embodiments can also be used to manufacture a liquid-crystal display device as a micro device by forming predetermined patterns (circuit pattern, electrode pattern, etc.) on plates (glass substrates). An example of a method in this case will be described below with reference to the flowchart of Fig. 21. In Fig. 21, a pattern forming step 401 is to execute the so-called photolithography step of transferring patterns on masks onto a photosensitive substrate (a glass substrate coated with a resist or the like) by means of the exposure apparatus of the embodiments. This photolithography step results in forming a predetermined pattern including a large number of electrodes and others on the photosensitive substrate. Thereafter, the exposed substrate is processed through each of steps including a development step, an etching step, a resist removing step, etc. whereby the predetermined pattern is formed on the substrate, followed by the next color filter forming step 402.

The next color filter forming step 402 is to form a color filter in which a large number of sets of three dots corresponding to R (Red), G (Green), and B (Blue) are arrayed in a matrix pattern or in which sets of filters of three stripes of R, G, and B are arrayed in the horizontal scan line direction. After the color filter forming step 402, a cell assembling step 403 is executed. The cell assembling step 403 is to assemble a liquid crystal panel (liquid crystal cell) using the substrate with the predetermined pattern obtained in the pattern forming step 401, the color filter obtained in the color filter forming step 402, and others.

In the cell assembling step 403, the liquid crystal panel (liquid crystal cell) is manufactured, for example, by pouring a liquid crystal into between the substrate with the predetermined pattern obtained in the pattern forming step 401 and the color filter obtained in the color filter forming step 402. The subsequent module assembling step 404 is to attach various components such as electric circuits and backlights for display operation of the assembled liquid crystal panel (liquid crystal cell) to complete the liquid-crystal display device. The above-described manufacturing method of the liquid-crystal display device permits us to obtain the liquid-crystal display device with extremely fine circuit patterns at high throughput.

Each of the aforementioned embodiments used the KrF excimer laser light source or the ArF excimer laser light source as the light source, but the present invention does not have to be limited to these: the present invention can also be applied to the exposure apparatus using any other appropriate light source, e.g., an F₂ laser light source. Each of the aforementioned embodiments described the present invention using the example of illumination optical apparatus mounted on the exposure apparatus and adapted to illuminate the masks, but it is apparent that the present invention can be applied to the generally-used illumination optical apparatus for illuminating any illumination target surface other than the masks. As described above, the present invention is not limited to the above-described embodiments but can be carried out in various configurations without departing from the spirit and scope of the present invention.

## Claims

1. An illumination optical apparatus comprising: a first illumination system including a first illumination optical path and illuminating a first illumination region; and a second illumination system including a second illumination optical path independent of the first illumination optical path and illuminating a second illumination region,
wherein the first illumination system includes a first variable system which varies a shape or size of a light intensity distribution on an illumination pupil of the first illumination system,
wherein the second illumination system includes a second variable system which varies a shape or size of a light intensity distribution on an illumination pupil of the second illumination system, and
wherein the first variable system and the second variable system vary the light intensity distribution on the illumination pupil of the first illumination system and the light intensity distribution on the illumination pupil of the second illumination system independently of each other.

2. The illumination optical apparatus according to claim 1,
wherein the first illumination system includes a first polarization setting unit which sets a polarization state of light to illuminate the first illumination region, to a desired polarization state,
wherein the second illumination system includes a second polarization setting unit which sets a polarization state of light to illuminate the second illumination region, to a desired polarization state, and
wherein the first polarization setting unit and the second polarization setting unit vary the polarization state of the light to illuminate the first illumination region and the polarization state of the light to illuminate the second illumination region, independently of each other.

3. The illumination optical apparatus according to claim 1 or 2,
wherein the first variable system includes a first shape varying system which varies the shape of the light intensity distribution on the illumination pupil of the first illumination system, and
wherein the second variable system includes a second shape varying system which varies the shape of the light intensity distribution on the illumination pupil of the second illumination system.

4. The illumination optical apparatus according to claim 3,
wherein the first shape varying system includes a plurality of interchangeable diffractive optical elements each of which diffracts incident light to form a desired light intensity distribution, in order to vary the shape of the light intensity distribution on the illumination pupil of the first illumination system, and
wherein the second shape varying system includes a plurality of interchangeable diffractive optical elements each of which diffracts incident light to form a desired light intensity distribution, in order to vary the shape of the light intensity distribution on the illumination pupil of the second illumination system

5. The illumination optical apparatus according to claim 3 or 4,
wherein the first shape varying system includes two prism members a spacing between which along an optical axis of the first illumination system is variable, in order to vary the shape of the light intensity distribution on the illumination pupil of the first illumination system, and
wherein the second shape varying system includes two prism members a spacing between which along an optical axis of the second illumination system is variable, in order to vary the shape of the light intensity distribution on the illumination pupil of the second illumination system.

6. The illumination optical apparatus according to any one of claims 1 to 5,
wherein the first variable system includes a first power varying system which varies the size of the light intensity distribution on the illumination pupil of the first illumination system, and
wherein the second variable system includes a second power varying system which varies the size of the light intensity distribution on the illumination pupil of the second illumination system

7. The illumination optical apparatus according to claim 6,
wherein the first power varying system includes a plurality of optical elements movable along an optical axis of the first illumination system, in order to vary the size of the light intensity distribution on the illumination pupil of the first illumination system, and
wherein the second power varying system includes a plurality of optical elements movable along an optical axis of the second illumination system, in order to vary the size of the light intensity distribution on the illumination pupil of the second illumination system.

8. The illumination optical apparatus according to any one of claims 2 to 7,
wherein the first polarization setting unit includes a first polarizing member which sets the polarization state of the light to illuminate the first illumination region, to a linearly polarized state with polarization along a desired direction, and
wherein the second polarization setting unit includes a second polarizing member which sets the polarization state of the light to illuminate the second illumination region, to a linearly polarized state with polarization along a desired direction.

9. The illumination optical apparatus according to any one of claims 1 to 8,
wherein the first illumination system includes a first optical integrator which uniformizes light to illuminate the first illumination region, and
wherein the second illumination system includes a second optical integrator which uniformizes light to illuminate the second illumination region.

10. The illumination optical apparatus according to any one of claims 1 to 9, comprising a light splitting member which splits incident light into two beams, guides one of the two split beams to the first illumination optical path, and guides the other beam to the second illumination optical path.

11. An illumination optical apparatus comprising: a first illumination system including a first illumination optical path and illuminating a first illumination region; and a second illumination system including a second illumination optical path independent of the first illumination optical path and illuminating a second illumination region,
wherein the first illumination system includes a first polarization setting unit which sets a polarization state of light to illuminate the first illumination region, to a desired polarization state,
wherein the second illumination system includes a second polarization setting unit which sets a polarization state of light to illuminate the second illumination region, to a desired polarization state, and
wherein the first polarization setting unit and the second polarization setting unit vary the polarization state of the light to illuminate the first illumination region and the polarization state of the light to illuminate the second illumination region, independently of each other,
the illumination optical apparatus further comprising a light splitting member which splits incident light into two beams, guides one of the two split beams to the first illumination optical path, and guides the other beam to the second illumination optical path.

12. The illumination optical apparatus according to claim 10 or 11, wherein the light splitting member comprises a polarization beam splitter.

13. The illumination optical apparatus according to any one of claims 10 to 12, comprising a common light source which supplies the incident light to the light splitting member.

14. The illumination optical apparatus according to any one of claims 1 to 13, wherein the first illumination system and the second illumination system illuminate the first illumination region and the second illumination region simultaneously.

15. The illumination optical apparatus according to any one of claims 1 to 13, wherein the first illumination system and the second illumination system illuminate the first illumination region and the second illumination region nonsimultaneously.

16. The illumination optical apparatus according to claim 15, wherein a control signal to control supply timing of illumination light is sent to a first light source supplying the illumination light to the first illumination system and to a second light source supplying the illumination light to the second illumination system.

17. The illumination optical apparatus according to any one of claims 1 to 16, wherein the first illumination region is spatially separated from the second illumination region.

18. The illumination optical apparatus according to any one of claims 1 to 17, wherein the first illumination optical path is spatially or temporally separated from the second illumination optical path.

19. The illumination optical apparatus according to any one of claims 1 to 18, wherein illumination light is guided to a projection optical system which forms an image of a first object illuminated by the first illumination system and an image of a second object illuminated by the second illumination system, in proximity or in superposition on a predetermined surface.

20. An exposure apparatus comprising the illumination optical apparatus as set forth in any one of claims 1 to 19, and performing an exposure of a pattern illuminated by the illumination optical apparatus, on a photosensitive substrate.

21. The exposure apparatus according to claim 20, comprising a projection optical system for projecting a pattern image of a first mask illuminated with light incident to the first illumination region and a pattern image of a second mask illuminated with light incident to the second illumination region, onto the photosensitive substrate.

22. The exposure apparatus according to claim 20 or 21, comprising: a control unit controlling the first variable system and the second variable system independently; and an input unit feeding exposure information of the photosensitive substrate,
wherein the control unit controls the first variable system and the second variable system independently, based on the information from the input unit.

23. A device manufacturing method comprising:
an exposure step of effecting the exposure of the pattern on the photosensitive substrate, using the exposure apparatus as set forth in any one of claims 20 to 22; and
a development step of developing the photosensitive substrate after the exposure step.
